(19) Europäisches Patentamt
European Patent Office
Office européen des brevets

(11) **EP 3 663 988 B1**

(12) **FASCICULE DE BREVET EUROPEEN**

(45) Date de publication et mention de la délivrance du brevet:
**18.05.2022 Bulletin 2022/20**

(21) Numéro de dépôt: **19212046.7**

(22) Date de dépôt: **28.11.2019**

(51) Classification Internationale des Brevets (IPC):
**G06N 3/04** *(2006.01)*    **G06N 3/063** *(2006.01)*

(52) Classification Coopérative des Brevets (CPC):
**G06N 3/0635; G06N 3/049**

(54) **NEURONE ARTIFICIEL POUR PUCE NEUROMORPHIQUE À SYNAPSES RÉSISTIVES**

KÜNSTLICHES NEURON FÜR NEUROMORPHEN CHIP MIT RESISTIVEN SYNAPSEN

ARTIFICIAL NEURON FOR NEUROMORPHIC CHIP WITH RESISTIVE SYNAPSES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.12.2018 FR 1872515**

(43) Date de publication de la demande:
**10.06.2020 Bulletin 2020/24**

(73) Titulaire: **Commissariat à l'énergie atomique et aux énergies alternatives 75015 Paris (FR)**

(72) Inventeurs:
• **Rummens, François 38054 GRENOBLE Cedex 09 (FR)**
• **Valentian, Alexandre 38054 GRENOBLE Cedex 09 (FR)**

(74) Mandataire: **Brevalex 95, rue d'Amsterdam 75378 Paris Cedex 8 (FR)**

(56) Documents cités:
WO-A1-2018/201060     US-A1- 2017 243 108
US-A1- 2018 260 696

• Eero Lehtonen ET AL: "Memristive Synapses Are Becoming Reality Master's thesis View project Gyrocardiography View project", , 31 janvier 2010 (2010-01-31), XP055614483, Extrait de l'Internet: URL:https://www.researchgate.net/profile/P iotr_Dudek4/publication/49288092_Memristiv e_Synapses_Are_Becoming_Reality/links/5575 9d8b08aeb6d8c01978c2/Memristive-Synapses-A re-Becoming-Reality.pdf [extrait le 2019-08-21]
• Olga Krestinskaya ET AL: "Neuro-memristive Circuits for Edge Computing: A review", , 28 novembre 2018 (2018-11-28), XP055614484, DOI: 10.1109/TNNLS.2019.2899262 Extrait de l'Internet: URL:https://arxiv.org/pdf/1807.00962.pdf [extrait le 2019-08-21]
• VAN SCHAIK A ED - ROY ASIM ET AL: "Building blocks for electronic spiking neural networks", NEURAL NETWO, ELSEVIER SCIENCE PUBLISHERS, BARKING, GB, vol. 14, no. 6-7, 9 juillet 2001 (2001-07-09), pages 617-628, XP004310067, ISSN: 0893-6080, DOI: 10.1016/S0893-6080(01)00067-3

## Description

## DOMAINE TECHNIQUE

Le domaine de l'invention est celui des puces neuromorphiques à réseaux de neurones artificiels exploitant des synapses à mémoire résistive.

## TECHNIQUE ANTÉRIEURE

A. van Schaik: "Building blocks for electronic spiking neural networks", Neural Networks, vol. 14, p. 617-628, 9 juillet 2001, divulgue un circuit électronique pour la modélisation d'un neurone biologique, avec la tension aux bornes d'un accumulateur représentant la tension de membrane du neurone. Le contrôle du poids synaptique peut y être effectué au moyen de la durée des potentiels d'action.

Une cellule nerveuse, ou neurone, peut être décomposée en plusieurs parties :

- Les dendrites qui sont les entrées du neurone via lesquelles il reçoit des signaux d'excitation ou d'inhibition ;
- Le corps du neurone qui est le théâtre d'échanges ioniques à travers la membrane cellulaire ;
- L'axone, une longue extension du corps cellulaire, qui est l'unique sortie du corps.

Selon les signaux d'excitation ou d'inhibition reçus au niveau des dendrites, des ions transitent à travers la membrane cellulaire. Le déséquilibre de charges entre l'intérieur et l'extérieur de la cellule induit une différence de tension de part et d'autre de la membrane. On parle alors de tension de membrane aux bornes d'une capacité de membrane. Lorsque cette tension de membrane dépasse un certain niveau, c'est-à-dire lorsque la cellule est suffisamment excitée, le neurone connait un échange brutal d'ions. Il en résulte une variation significative de la tension de membrane. Cette variation, appelée potentiel d'action (« action potential » ou encore « spike » en anglais), se propage le long de l'axone, vers les boutons synaptiques qui constituent les sorties du neurone. Vus de l'extérieur de la cellule, ces « spikes » constituent l'activité électrique du neurone.

Dans un réseau de neurones biologiques, chaque neurone est connecté à plusieurs milliers d'autres via autant de synapses. Le terme synapse désigne la connexion entre la terminaison axonique d'un neurone dit présynaptique et une dendrite d'un neurone dit postsynaptique. L'influence du neurone présynaptique sur le neurone postsynaptique est pondérée par le poids de la synapse qui peut être excitatrice ou inhibitrice. Dans le premier cas, un « spike » présynaptique charge la tension de membrane du neurone postsynaptique et précipite la génération d'un potentiel d'action postsynaptique. Dans le second cas, un « spike » présynaptique a pour effet de dépolariser la membrane postsynaptique et de retarder l'apparition d'un potentiel d'action postsynaptique.

Les réseaux de neurones artificiels sont utilisés dans différents domaines de traitement du signal comme par exemple en classification de données, en reconnaissance d'images ou en prise de décision. Ils sont inspirés des réseaux de neurones biologiques dont ils imitent le fonctionnement et sont essentiellement composés de neurones artificiels interconnectés entre eux par des synapses qui peuvent être implémentées par des composants résistifs dont la conductance varie en fonction de la tension appliquée à leurs bornes.

De par leur grande densité et leur caractère non-volatil, ces composants résistifs (memristors ou RRAM) sont des candidats idéaux à l'implémentation des synapses. La résistance variable de ces composants peut être augmentée (opération dite *Reset*) ou diminuée (opération *Set*) si on y applique des grandeurs électriques (tension et/ou courant) relativement élevées. Si on veut simplement lire la valeur de leur résistance sans la modifier (opération *Read*), il faut appliquer des grandeurs électriques relativement faibles.

L'intégration de synapses résistives prend souvent la forme d'un plan mémoire, qu'on nomme « plan synaptique », dans lequel les synapses sont agencées en un réseau à lignes et colonnes transversales qui permet de relier une couche de neurones d'entrée (les neurones présynaptiques) et une couche de neurones de sortie (les neurones postsynaptiques). Chaque synapse dispose d'une borne d'activation de la synapse et d'une borne de propagation d'un signal synaptique. Les bornes d'activation des synapses d'une même ligne sont reliées entre elles par l'intermédiaire d'une ligne de mot (ou « Word-Line »), et les bornes de propagation des synapses d'une même colonne sont reliées entre elles et connectées à un neurone artificiel par l'intermédiaire d'une ligne de bit (ou « Bit-Line »). Une ligne de mot est utilisée pour injecter une impulsion en tension dans les synapses de la ligne correspondante et les lignes de bit sont les sorties de ces synapses. En présence d'une activation présynaptique sur une ligne de mot depuis un neurone présynaptique, chaque ligne de bit propage un courant pondéré par la valeur de la mémoire résistive correspondante vers un neurone postynaptique.

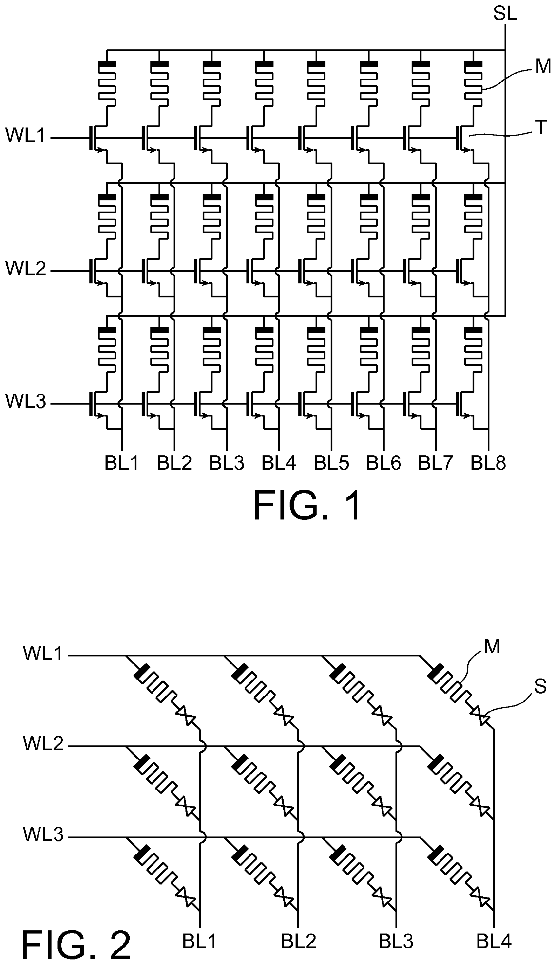

Comme représenté en figure 1 (dans ce qui suit figure x désigne la figure annexée Fig. x), une synapse à mémoire résistive prend généralement la forme d'une cellule 1T1R composée d'une résistance variable M et d'un transistor d'accès T servant à réguler les courants d'écriture et dont la grille forme la borne d'activation de la synapse. On a représenté sur la figure 1 un exemple d'un plan synaptique à cellules 1T1R comprenant trois lignes de mot WL1-WL3, huit lignes de bit BL1-BL8 chacune destinée à être reliée à un neurone de sortie et une ligne de source (ou « Source-Line ») SL reliée à toutes les synapses. La présence d'un transistor par synapse limite néanmoins la densité d'un tel plan synaptique.

Comme représenté en figure 2, on peut alternativement avoir recours à des cellules 1S1R composée d'une résistance variable M et d'un sélecteur S ayant un comportement similaire à une diode, voire à deux diodes en tête-bêche. Chaque cellule 1S1R est un dipôle dont les bornes constituent les bornes d'activation et de propagation, et le plan synaptique s'organise comme représenté en figure 2 où l'on a pris l'exemple d'un plan comprenant trois lignes de mots WL1-WL3 et de quatre lignes de bits BL1-BL4, et où chaque synapse est prise entre une tension sur la ligne de mot correspondante et une tension sur sa ligne de bit correspondante.

Un certain nombre de contraintes pèsent sur l'implémentation effective d'un tel réseau de neurones artificiels.

Par exemple, si l'organisation du plan synaptique présente des avantages (parallélisation des calculs, densité, mise en commun des pilotes), elle présente néanmoins des limitations. Tout d'abord, cette organisation offre une connexion « tous-à-tous » selon laquelle tous les neurones présynaptiques sont connectés via une synapse à tous les neurones postsynaptiques. Or dans certains cas, cette connexion « tous-à-tous » peut conduire à une matrice synaptique principalement nulle et donc à une faible efficacité énergétique. Cette organisation nécessite également de devoir traiter finement les poids nuls sous peine d'avoir un réseau composé principalement de synapses parasites, rendant encore plus complexe l'intégration analogique des poids synaptiques.

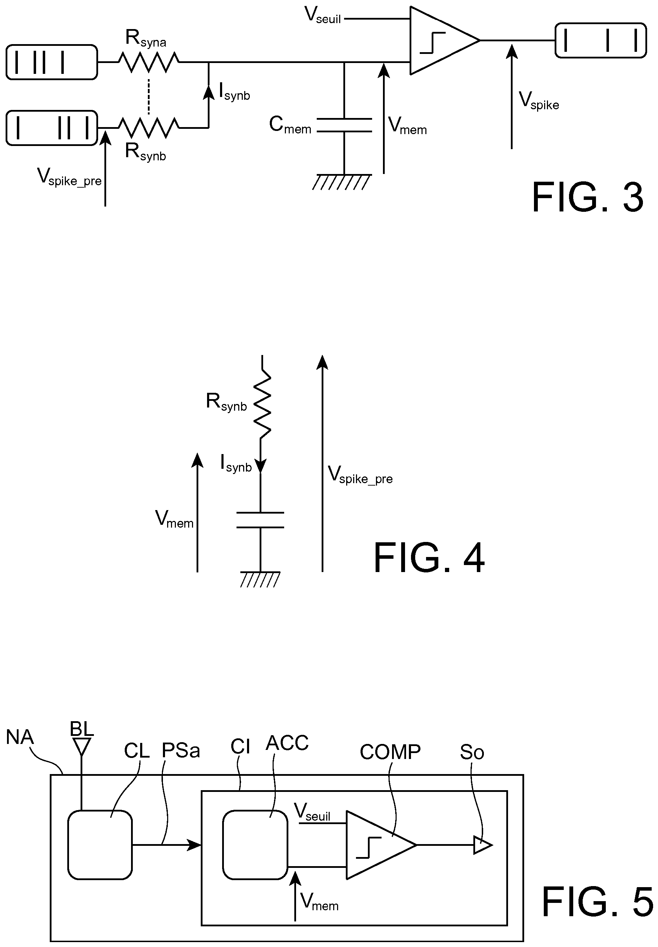

Une autre contrainte est liée à l'implémentation classique d'un neurone artificiel sous la forme d'un neurone intégratif à seuil (« Integrate and Fire » en anglais). Le principe d'une telle implémentation est représenté sur la figure 3. La contribution $V_{spike\_pre}$ d'un neurone présynaptique est pondérée par la valeur de la résistance synaptique correspondante $R_{synb}$ et fournit ainsi un courant d'excitation $I_{synb}$. Ce courant est injecté dans une capacité $C_{mem}$ qui intègre les différentes stimulations au cours du temps. La tension de membrane, modélisée par la tension $V_{mem}$ aux bornes de la capacité $C_{mem}$, est comparée à un seuil $V_{seuil}$. Lorsque ce seuil est dépassé par la tension de membrane, un spike $V_{spike}$ est émis et la capacité $C_{mem}$ est déchargée pour réinitialiser la tension de membrane, typiquement en la remettant à zéro.

Or selon la loi d'Ohm, et comme représenté en figure 4, le courant $I_{synb}$ qui devrait ne dépendre que de la valeur de la résistance $R_{synb}$ de la synapse dépend en réalité de la valeur de la tension de membrane

$$V_{mem} : I_{synb} = \frac{V_{spike\text{-}pre} - V_{mem}}{R_{synb}}.$$

Ceci implique que plus la tension $V_{mem}$ est élevée, donc plus le neurone est excité et susceptible d'émettre un spike, moins ses synapses afférentes ont un effet sur lui. Un tel phénomène est problématique. Ainsi, dans une couche de classification par exemple, le neurone censé émettre le plus de spikes voit son activité réduite dans une plus grande proportion que celle des neurones moins actifs. Dès lors, la différence entre ce neurone « gagnant » et les autres neurones se trouve réduite.

D'autres contraintes sont liées aux caractéristiques des mémoires RRAM. Un exemple de telle mémoire RRAM est la mémoire OxRAM qui est composée d'un isolant coincé entre deux couches de conducteurs. Lors d'une première étape de formation, un fil conducteur croît depuis l'un des conducteurs vers l'autre, réduisant ainsi la résistance totale du dipôle. Une fois ce fil formé, les actions d'écriture agissent sur sa longueur pour faire varier la résistance. Une opération *Set* allonge le fil et réduit la résistance tandis qu'une opération *Reset* a l'effet inverse. La lecture d'une mémoire OxRAM présente une difficulté, celle de l'écriture parasite en venant petit à petit modifier la valeur de la résistance au fil de lectures successives. Pour limiter ce risque, il est conseillé d'appliquer une tension de lecture maximale de 100 mV. La petitesse de cette tension complique grandement la mise en œuvre d'une lecture analogique intégrative de ces mémoires. En effet, la tension de lecture $V_{spike\_pre}$ limite la tension de membrane $V_{mem}$, car la capacité de membrane $C_{mem}$ est chargée à travers la résistance $R_{synb}$ sur laquelle est appliquée $V_{spike\_pre}$. Autrement dit, la tension de membrane vaut au plus la tension $V_{spike\_pre}$. Or $V_{mem}$ étant un élément de calcul analogique donc soumis notamment à des problématiques de bruit, de variations technologiques, de couplage capacitif, sa gamme de tension ne peut être réduite à une valeur aussi faible que 100 mV sans augmenter fortement les sources d'erreurs de calcul.

On relèvera par ailleurs que les dispositifs RRAMs ont souvent une gamme de résistance faible (avec des valeurs basses de l'ordre du kΩ) et que l'on peut donc être confronté à des constantes de temps du coupe $R_{syn}$ - $C_{mem}$ de l'ordre de la nanoseconde voire moins. Or il n'est pas aisé de générer des impulsions de lecture inférieures à 1 ns, sauf à avoir recours à un circuit spécifique. L'impulsion de lecture doit en outre être propagée sur toute la largeur du plan synaptique. Or plus cette impulsion est courte, moins elle est « propre » en bout de ligne. Enfin, une telle impulsion se propage difficilement dans des circuits analogiques actifs chargés d'intégrer le courant de lecture sans être confrontée à des problématiques de bande passante et/ou de distorsion.

## EXPOSÉ DE L'INVENTION

L'invention a pour objectif d'apporter une solution permettant de répondre à l'une et/ou l'autre des contraintes susmentionnées. Elle est exposée dans le jeu de revendications joint.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins suivants sur lesquels, outre les figures 1 à 4 déjà discutées précédemment :

- la figure 5 est un schéma de principe d'un neurone artificiel ;
- la figure 6 illustre une synapse excitatrice ou inhibitrice pouvant être utilisée dans le cadre de l'invention ;
- la figure 7 représente la réponse impulsionnelle de la synapse de la figure 6 ;
- les figures 8 et 9 fournissent des exemples d'intégration de la synapse de la figure 6 dans un plan synaptique ;
- les figures 10 et 11 fournissent un autre exemple de synapse excitatrice ou inhibitrice pouvant être utilisée dans le cadre de l'invention ;
- les figures 12 et 13 sont des schémas de neurones artificiels disposant d'un accumulateur de courant synaptique dans le circuit de lecture et d'un accumulateur de poids synaptiques dans le circuit d'intégration et pour lesquels la grandeur analogique représentative du poids synaptique fournie par le circuit de lecture au circuit d'intégration est une tension ;
- la figure 14 représente un autre exemple de neurone pour lequel la grandeur analogique est également une tension ;
- la figure 15 représente un neurone selon l'invention pour lequel la grandeur analogique est une durée ;
- la figure 16 illustre un autre mode opératoire du neurone de la figure 15 ;
- les figures 17, 18 et 20 représentent des circuits de lecture d'un exemple de neurone pour lequel la grandeur analogique est un courant ;
- la figure 19 illustre une variante de réalisation des circuits de lectures des figures 17 et 18.

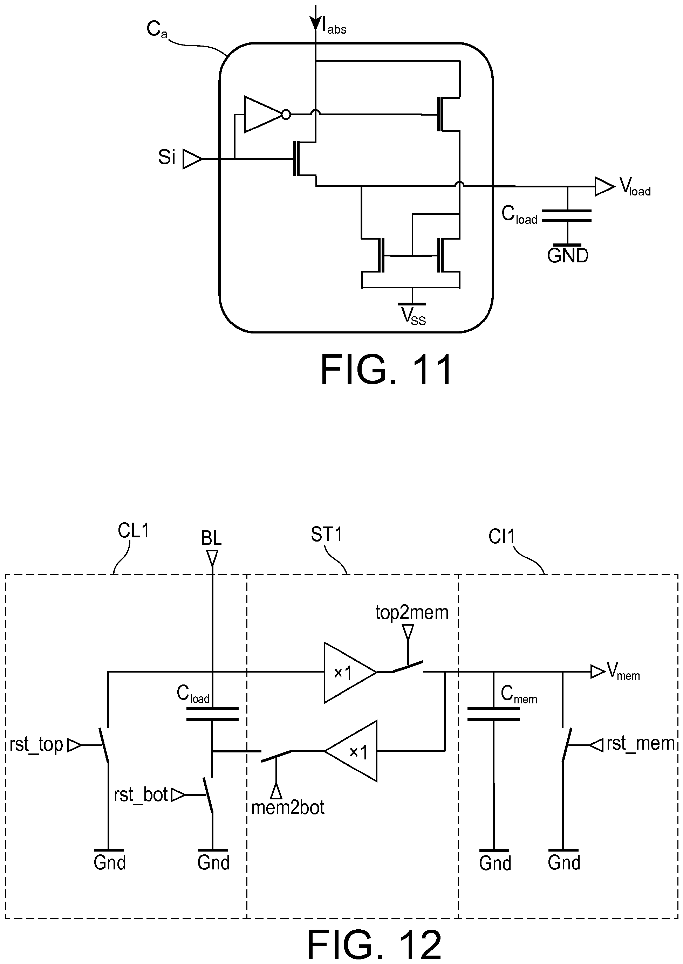

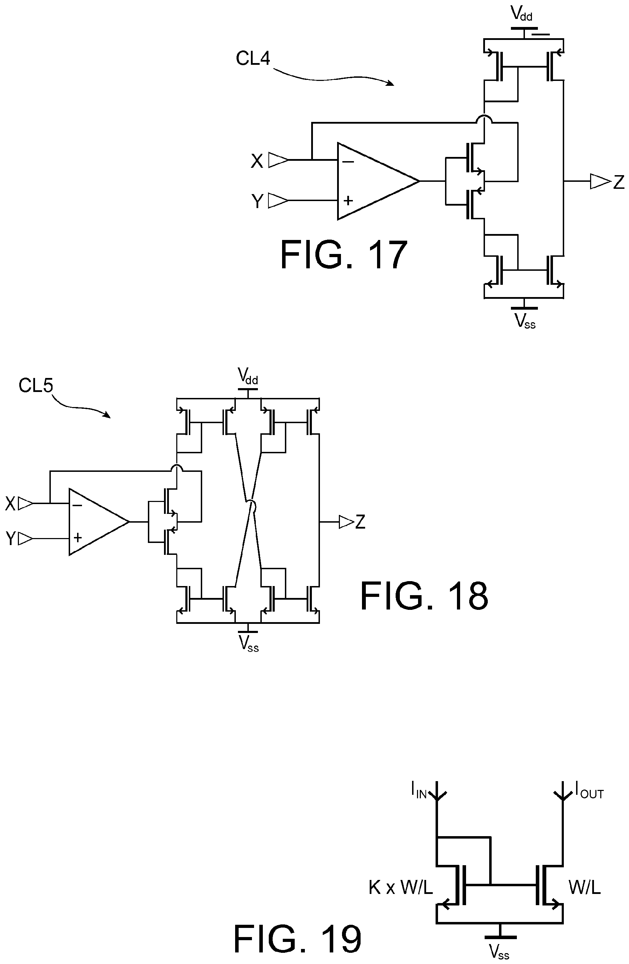

Les modes de réalisation selon lesquels la grandeur analogique représentative du poids synaptique est une tension (figures 12-14), ou un courant (figures 17-20), ne relèvent pas de l'invention et ne sont présents qu'à titre illustratif.

## DESCRIPTION DETAILLEE

En référence à la figure 5, l'invention porte sur un neurone artificiel NA pour puce neuromorphique comprenant une synapse à mémoire résistive représentative d'un poids synaptique.

La synapse dispose d'une borne d'activation de la synapse et d'une borne de propagation d'un signal synaptique. En présence d'une activation présynaptique appliquée sur la borne d'activation, la borne de propagation propage un signal synaptique représentatif de la valeur de la mémoire résistive (i.e. le poids synaptique) en direction du neurone artificiel NA par l'intermédiaire d'une ligne de bit BL.

Le neurone artificiel comprend un circuit d'intégration CI qui comprend un accumulateur de poids synaptiques ACC aux bornes duquel s'établit une tension de membrane $V_{mem}$ et un comparateur COMP configuré pour émettre une impulsion postsynaptique SO en cas de franchissement d'un seuil $V_{seuil}$ par la tension de membrane $V_{mem}$.

L'invention propose de découpler la lecture du poids synaptique de son intégration en évitant de numériser la lecture du poids synaptique. Les différentes contraintes peuvent ainsi être réparties selon qu'elles sont héritées de la technologie de la mémoire résistive ou du fonctionnement du neurone analogique. Pour ce faire, l'invention propose plus particulièrement que le neurone artificiel NA comporte en outre un circuit de lecture CL configuré pour imposer à la synapse une tension de lecture indépendante de la tension de membrane $V_{mem}$ et pour fournir au circuit d'intégration CI une grandeur analogique représentative du poids synaptique PSa.

Le circuit de lecture CL permet ainsi d'imposer à la synapse une tension de lecture présentant une polarisation identique pour chaque lecture quel que soit l'état de la tension de membrane $V_{mem}$. Ce circuit de lecture permet également d'imposer à la synapse une tension de lecture suffisamment faible pour éviter tout risque d'écriture parasite. Le résultat de la lecture, à savoir la grandeur analogique représentative du poids synaptique PSa, est transmis au circuit d'intégration. Dans le cadre de l'invention, cette grandeur est une durée, tandis que dans d'autres modes de réalisation ne relevant pas de l'invention, cette grandeur peut prendre différentes autres formes, telles qu'une tension, un courant ou une charge par exemple.

Le circuit d'intégration CI, ainsi découplé de la lecture, peut ainsi proposer une vaste plage de tension pour la tension de membrane, indépendante des spécifications de la synapse.

On détaille dans ce qui suit des implémentations de synapses résistives qui trouvent avantageusement application dans le cadre de l'invention. On comprendra cependant que l'invention n'est pas limitée à ces implémentations spécifiques.

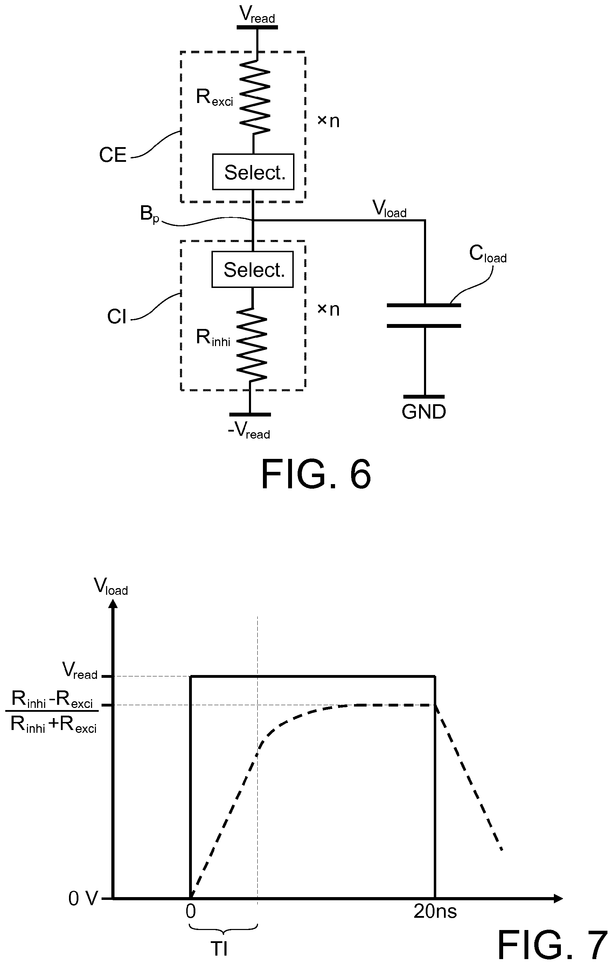

On peut en effet chercher à disposer de synapses qui puissent être à la fois excitatrices et inhibitrices, et qui doivent donc être capable à la fois d'injecter et de tirer du courant depuis le neurone. Les synapses étant ici résistives et le courant qu'elles pilotent dépendant de leur résistance, on prévoit deux niveaux de tension d'alimentation de la synapse, un positif et un négatif. La figure 6 fournit un exemple d'une telle synapse excitatrice et inhibitrice, dite synapse 2R1C. La synapse comprend une composante excitatrice CE et une composante inhibitrice CI agencées en série, avec pour point milieu la borne de propagation Bp de la synapse, entre une tension d'alimentation positive $V_{read}$ et une tension d'alimentation négative $-V_{read}$. Chacune de ces composantes peut être constituées de $n\geq 1$ cellules 1T1R ou 1S1R selon l'encodage choisi (sur la figure, la référence Select. désigne ainsi le transistor d'accès ou le sélecteur de telles cellules 1T1R ou 1S1R). Si on utilise des RRAMs multivaluées, on peut avoir n = 1. Si par contre on utilise des RRAMs binaires, on prévoit autant de cellules que de niveaux de poids désirés. On peut également utiliser des synapses valant -1, 0 ou +1, auquel cas on peut utiliser des RRAMs binaires et n = 1. Quoi qu'il en soit, on fait dans ce qui suit référence à la résistance totale des cellules en parallèle en écrivant $R_{exci}$ et $R_{inhi}$ pour désigner respectivement la résistance totale de la composante excitatrice CE et la résistance totale de la composante inhibitrice CI. Sur la figure 6, la capacité $C_{load}$ fait partie du circuit de lecture d'un neurone selon une réalisation possible de l'invention et est donc partagée par toutes les synapses d'une même colonne.

Le poids de la synapse est encodé comme suit. Si on veut une synapse excitatrice, la résistance $R_{inhi}$ est réglée à son niveau de résistance maximal, tandis que la résistance $R_{exci}$ ($<R_{inhi}$) module le poids positif de la synapse. Plus la résistance $R_{exci}$ est faible, plus le poids synaptique est important, car il en résulte un courant synaptique supérieur. A contrario, si on veut une synapse inhibitrice, la résistance $R_{exci}$ est réglée à son niveau de résistance maximal, tandis que la résistance $R_{inhi}$ ($<R_{exci}$) module le poids négatif de la synapse

En négligeant les effets des sélecteurs ou transistors d'accès, le schéma composé de la capacité $C_{load}$ et de deux résistances $R_{inhi}$ et $R_{exci}$ s'apparente à un pont résistif amorti. En appliquant les tensions d'alimentation $V_{read}$ et $-V_{read}$, le potentiel $V_{load}$ à la borne de propagation Bp se charge alors progressivement comme représenté sur la figure 7. Cette figure 7 illustre que l'intégration du poids synaptique ne peut être effective que sur une période d'intégration PI correspondant à une durée d'impulsion de lecture inférieure à la constante de temps du couple $R_{syn}$ - $C_{load}$. Dans le cas contraire en effet, avec par exemple Rexci « $R_{inhi}$, on risque d'obtenir $V_{load}=V_{read}$ quelle que soit la valeur de $R_{exci}$.

Cette constante de temps est en outre encore plus brève lorsque l'on a recours à des RRAM binaires pour obtenir des synapses multivaluées, la mise en parallèle de ces RRAM binaires débouchant en effet sur une résistance globale plus faible. Ce problème peut être contourné en ayant recours à une lecture statique de la synapse, c'est-à-dire à la lecture d'une grandeur fonction du poids de la synapse qui est stabilisée en ce sens qu'elle est indépendante de la durée d'une impulsion de lecture. La figure 7 montre en effet qu'à l'état statique atteint avec une impulsion de lecture suffisamment longue, la valeur de $V_{load}$ peut effectivement être modulée par le rapport entre $R_{exci}$ et $R_{inhi}$ et donc en jouant avec le nombre de dispositifs en haute résistance (« High Resistive State », HRS) ou en basse résistance (« Low Resistive State », LRS) côté composante excitatrice et composant inhibitrice.

Prenant l'exemple d'une synapse composée de 8 dispositifs OxRAM, 4 pour la composante excitatrice et 4 pour la composante inhibitrice. Avec LRS = 3kΩ, HRS = 800kΩ et $C_{load}$ = 50 fF, un codage sur 9 poids (dont le poids nul) associés à des constantes de temps allant de 1 ns à 250 ps peut être obtenu. Une lecture statique offre quant à elle plus de combinaisons (13 poids possible) et évite d'avoir à générer des impulsions de lectures brèves. En revanche, cette lecture statique est plus énergivore en raison de l'accès « prolongé » à la RRAM.

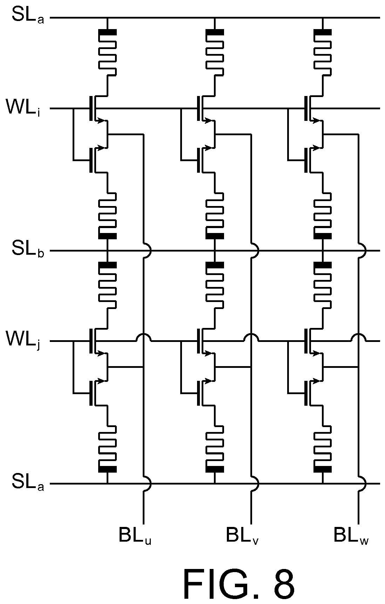

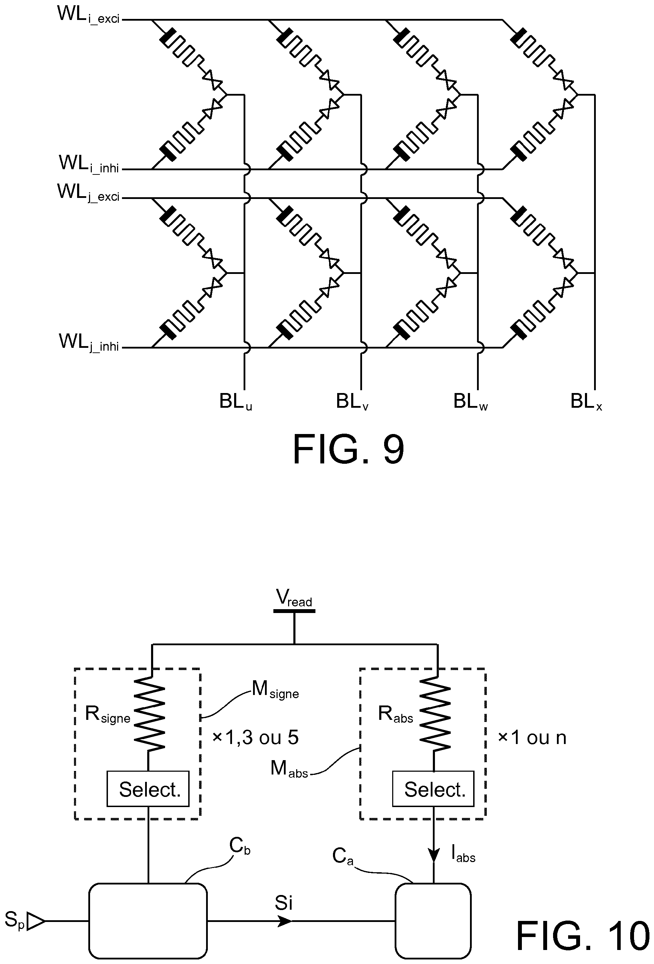

On a représenté sur les figures 8 et 9 une organisation possible du plan synaptique avec des synapses 2R1C conformes à celle de la figure 6 dans le cas où les composantes CE, CI sont respectivement basées sur des cellules 1T1R ou 1S1R.

Dans le cas 1T1R (figure 8), les composantes excitatrices et inhibitrices participant à la même synapse ont leur bornes d'activation WLi, $WL_j$ mises en commun. En effet, en phase de lecture, les deux composantes sont lues en même temps. Cette mise en commun est bienvenue car le plan synaptique est complexifié par la nécessité d'avoir deux réseaux de lignes de source distincts $SL_a$, SLb qui servent à distinguer les cellules aux BL et WL communs pendant la phase d'écriture et de polariser les synapses en $V_{read}$ ou $-V_{read}$ selon quelles encodent la composante excitatrice ou inhibitrice de leur synapse pendant la phase de lecture. Dans cette configuration, les grilles $SL_a$, SLb ont vocation à demeurer polarisées à $\pm V_{read}$ et les impulsions d'écriture entre la masse et $V_{DD}$ sont envoyées sur les bornes d'activation $WL_i$, $WL_j$. On note que les transistors d'accès des cellules inhibitrices sont polarisés en inverse.

Dans le cas 1S1R (figure 9), la composante excitatrice d'une synapse est prise entre une ligne de mot $WL_{i\_exci}$, $WL_{j\_exci}$ et une ligne de bit $BI_u$-$BI_x$ tandis que la composant inhibitrice de la même synapse est prise entre une ligne de mot $WL_{i\_inhi}$, $WL_{j\_inhi}$ et la ligne de bit $BI_u$-$BI_x$. Des impulsions de lectures sont envoyées simultanément sur les lignes de mot $WL_{i\_exci}$ et $WL_{i\_inhi}$ correspondant à un spike présynaptique afférent à la ligne i. La ligne de mot $WL_{i\_exci}$ subit une impulsion de la masse à $V_{read}$ et la ligne de mot $WL_{i\_inhi}$ subit une impulsion de la masse à $-V_{read}$.

On peut également rechercher à implémenter des spikes négatifs, à savoir des impulsions présynaptiques qui inversent le poids de la synapse qu'elles déclenchent.

Reprenant l'exemple de la figure 9, au lieu d'envoyer des créneaux positifs sur $WL_{i\_exci}$, $WL_{j\_exci}$ et négatifs sur $WL_{i\_inhi}$, $WL_{j\_inhi}$, il suffit d'inverser ces polarisations. Ainsi, une synapse inhibitrice injecte un courant dans $C_{load}$ et à l'inverse une synapse excitatrice en retire.

Reprenant l'exemple de la figure 8, en cas de spike négatif il est également possible d'inverser la polarisation de deux lignes de source $SL_a$, SLb. Cette solution n'est pas nécessairement favorable, car longue et couteuse en énergie du fait que ces lignes sont communes à tout le plan synaptique. En variante, il est possible d'utiliser une pilote par ligne de source et dont la polarisation est basculée de $V_{read}$ à -$V_{read}$ en fonction du signe de l'impulsion présynaptique à traiter. Dès lors, il n'est plus nécessaire de charger et décharger deux plans complets mais seulement les deux lignes de source $SL_a$ et $SL_b$ qui correspondent aux synapses excitées par une même impulsion présynaptique. Dans ce cadre, il est possible de déplacer la tension de ces lignes de source uniquement lors de la lecture et de les laisser à la masse sinon. Alternativement, ces lignes de source $SL_a$ et $SL_b$ peuvent changer de polarisation (de $V_{read}$ à -$V_{read}$ et inversement) uniquement lorsque cela est nécessaire en venant exploiter à cet effet une mémoire dans chaque pilote de ligne de source.

Les figures 10 et 11 illustrent un autre exemple de réalisation pour intégrer un poids signé analogique dans un plan synaptique selon laquelle on associe une valeur absolue analogique à un signe binaire au moyen d'une synapse dite dans ce qui suit synapse valeur absolue + signe. Le plan synaptique est alors plus classique, équipé d'une unique tension de lecture et présentant des courants de lecture unidirectionnels. Selon cet exemple, un certain nombre de RRAMs binaires, une RRAM multivaluée ou une unique RRAM binaire en cas de synapse binaire implémente(nt) la valeur absolue $R_{abs}$ du poids synaptique alors qu'une autre RRAM, modélisé par une résistance $R_{signe}$, est utilisée de façon binaire pour encoder le signe du poids synaptique. Cette RRAM de signe peut avantageusement être constituée par un triplé ou un quintuplé de dispositifs dont le signe de la synapse est extrait à la majorité. Le circuit de lecture du neurone artificiel comprend alors un circuit de lecture binaire Cb de la mémoire de signe de poids synaptique $M_{signe}$ et un circuit de lecture analogique Ca de la mémoire de valeur absolue de poids synaptique $M_{abs}$, ledit circuit de lecture analogique Ca étant piloté par le circuit de lecture binaire Cb. Le circuit de lecture binaire Cb exploite le signe du spike présynaptique Sp et le signe du poids synaptique $M_{signe}$ pour fournir au circuit de lecture analogique Ca un signe d'intégration Si indiquant dans quel sens intégrer le courant analogique $I_{abs}$ issu de la mémoire de valeur absolue de poids synaptique $M_{abs}$. Le sens du courant analogique $I_{abs}$ étant toujours le même, son inversion en cas de signe d'intégration négatif peut être réalisée avec un simple miroir de courant comme représenté en figure 11. Sur cette figure 11, si le signe d'intégration Si vaut 1, le courant $I_{abs}$ est injecté dans $C_{load}$. En revanche, si le signe d'intégration Si vaut 0, le courant $I_{abs}$ est retiré de $C_{load}$.

On a représenté sur les figures 12, 13 et 14 des exemples de réalisation d'un neurone artificiel ne relevant pas de l'invention et pour lesquels la grandeur analogique représentative du poids synaptique fournie par le circuit de lecture au circuit d'intégration est une tension. Dans certaines réalisations, la grandeur analogique représentative du poids synaptique peut être une tension indépendante de la durée d'une impulsion de lecture, les neurones réalisant une lecture statique de la synapse.

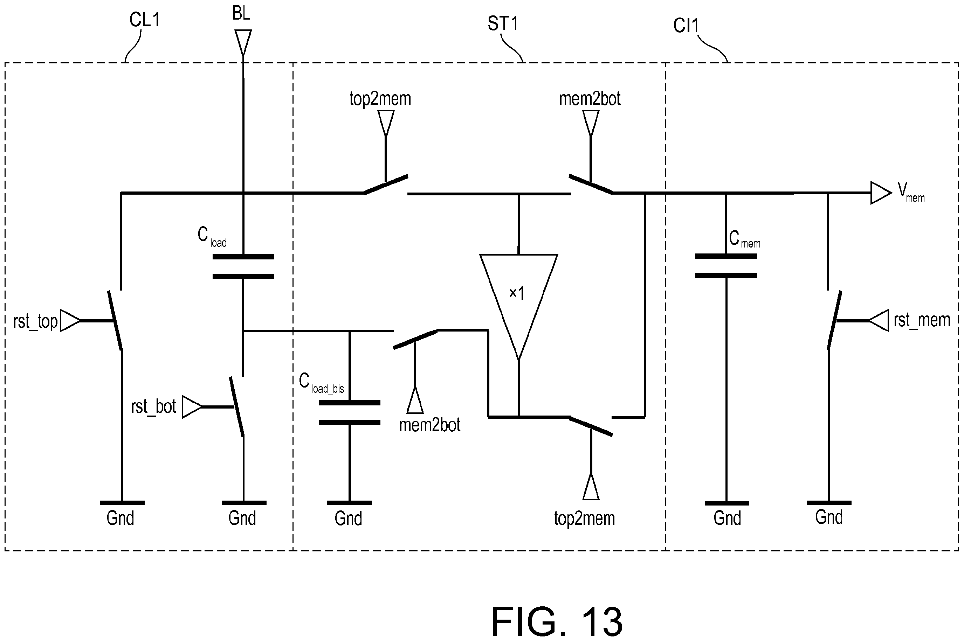

Sur les figures 12 et 13, le circuit de lecture CL1 comprend un accumulateur de courant synaptique $C_{load}$ aux bornes duquel s'établit une tension $V_{load}$, cette tension correspondant à la grandeur analogique représentative du poids synaptique. Le neurone artificiel comprend par ailleurs un circuit suiveur de tension bidirectionnel ST1, ST2 interposé entre le circuit de lecture CL1 et le circuit d'intégration CI1.

Le fonctionnement du neurone est le suivant. Lors d'une opération de lecture de la synapse, le pôle inférieur de $C_{load}$ est connecté à la masse virtuelle Gnd par un interrupteur rst_bot. Dans une première phase de l'opération de lecture, $C_{load}$ est d'abord déchargée en reliant son pôle supérieur à la masse virtuelle à l'aide d'un interrupteur rst_top, le circuit de lecture étant ainsi configuré pour décharger l'accumulateur de courant synaptique $C_{load}$ avant d'imposer la tension de lecture à la synapse. La lecture de la synapse est ensuite déclenchée par l'ouverture de l'interrupteur rst_top. Le courant provenant de la ligne de bit BL est alors accumulé dans $C_{load}$, générant la tension de lecture $V_{load}$. L'ouverture de rst_bot permet d'obtenir une tension $V_{load}$ flottante. Le suiveur de tension ST1, ST2 est alors configuré pour recopier la tension de membrane $V_{mem}$ à la borne inférieure de $C_{load}$. Ainsi la tension à la borne supérieure de $C_{load}$ vaut l'addition de $V_{mem}$ et $V_{load}$. Puis le suiveur de tension ST1, ST2 est configuré pour recopier cette addition de tension à la borne supérieure de la capacité de membrane $C_{mem}$ fournissant ainsi la nouvelle tension de membrane qui est comparée au(x) seuil(s) d'émission de spike(s).

L'addition analogique de tension proposée dans les exemples de réalisation de figures 11 et 12 permet de procéder à une lecture statique de la synapse 2R1C. La lecture dynamique est également possible à condition de générer une impulsion de lecture suffisamment brève. Dans ces exemples par ailleurs, la stimulation maximale est limitée par la tension de lecture des RRAMs. On peut alors choisir qu'une telle stimulation maximale permet à elle seul de déclencher un spike postsynaptique par un neurone dont la tension de membrane serait à son potentiel de repos. Auquel cas, la gamme de tension de la tension de membrane $V_{mem}$ est limitée par la tension de lecture $V_{read}$. Alternativement, on ne prévoit pas une telle caractéristique de stimulation, et on peut étaler la tension de membrane $V_{mem}$ sur une plage de tension plus vaste.

Sur la figure 12, le suiveur de tension ST1 comprend deux amplificateurs opérationnels, l'un destiné via l'interrupteur mem2bot à recopier la tension de membrane à la borne inférieure de $C_{load}$ et l'autre destiné via l'interrupteur top2mem à recopier l'addition de tension à la borne supérieure de $C_{mem}$.

Sur la figure 13, le suiveur de tension ST2 comprend un seul amplificateur opérationnel en lieu et place des deux amplificateurs opérationnels utilisés alternativement sur la figure 12. Afin de contrecarrer l'influence des capacités parasites des interrupteurs lors des transferts de charge au niveau de l'entrée de l'amplificateur opérationnel, on prévoit une capacité additionnelle $C_{load\_bis}$ en parallèle de l'interrupteur rst_bot.

On relèvera que la synapse valeur absolue + signe est adaptée aux neurones des figures 12 et 13.

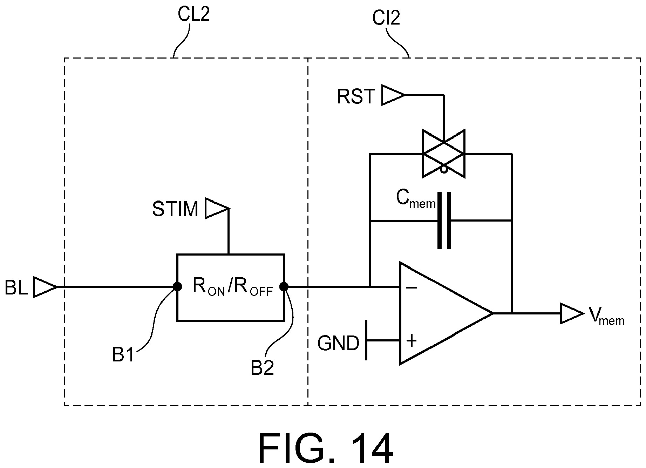

Sur la figure 14 qui propose également une grandeur analogique représentative du poids synaptique sous la forme d'une tension, le circuit de lecture CL2 comprend un commutateur $R_{ON}/R_{OFF}$ ayant une première borne B1 destinée à être reliée à la synapse via la ligne de bit BL et une deuxième borne B2 reliée au circuit d'intégration CI2. Le circuit d'intégration CI2 comprend un montage intégrateur relié à la deuxième borne et au sein duquel est monté l'accumulateur de poids synaptique $C_{mem}$.

La lecture de la synapse s'opère comme suit. Dans un premier temps, on laisse le commutateur ouvert (il présente une résistance $R_{OFF}$ dans son état bloqué), la tension sur la ligne de bit $V_{BL}$ se stabilise suivant le poids de la synapse (on doit donc avoir $R_{OFF}$>>HRS). Dans un second temps, le commutateur est fermé (il présente une résistance $R_{ON}$ dans son état passant), la tension $V_{BL}$ est intégrée par le montage intégrateur dont la constante de temps dépend de $R_{ON}$ et $C_{mem}$ et pas du LRS des RRAMs. On a donc $R_{ON}$>LRS. Le neurone de la figure 14 réalise ainsi une lecture statique de la synapse au moyen du commutateur $R_{ON}/R_{OFF}$ et une intégration de la tension $V_{BL}$.

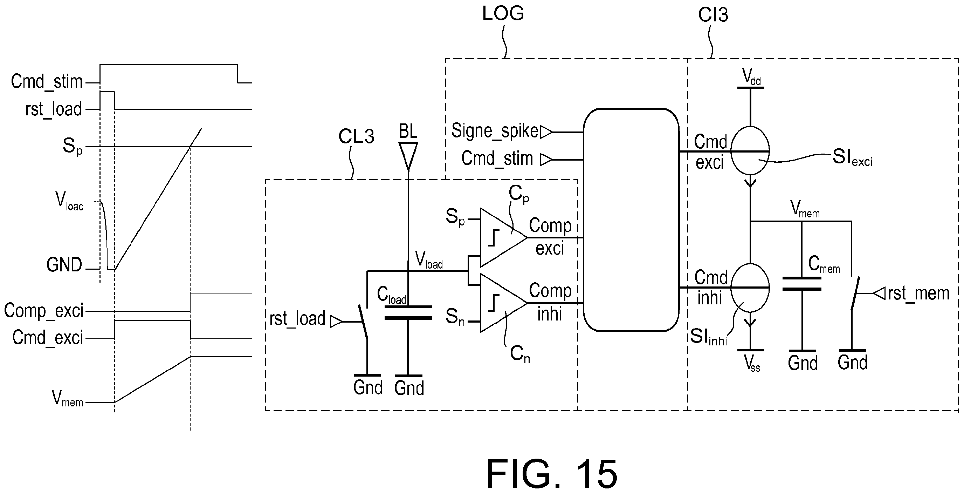

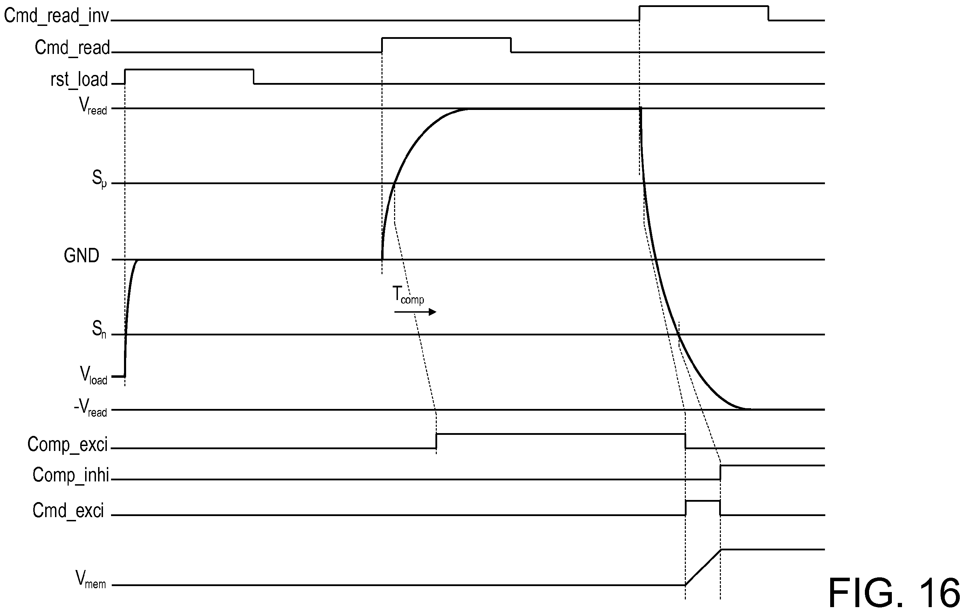

On a représenté sur les figures 15 et 16 des exemples de réalisation d'un neurone artificiel selon l'invention pour lesquels la grandeur analogique représentative du poids synaptique fournie par le circuit de lecture au circuit d'intégration est une durée. Dans ces exemples, le neurone comprend un circuit logique LOG interposé entre le circuit de lecture CL3 et le circuit d'intégration CI3, le circuit logique étant configuré pour générer à partir de ladite grandeur analogique une impulsion Cmd_exci, Cmd_inhi présentant ladite durée. Le circuit d'intégration CI3 comprend quant à lui une source de courant $SI_{exc}$, $SI_{inhi}$ pilotée par ladite impulsion pour injecter un courant dans l'accumulateur de poids synaptiques pendant ladite durée.

Comme pour les neurones des figures 12 et 13, le circuit de lecture CL3 du neurone représenté en figure 15 comprend un accumulateur de courant synaptique $C_{load}$ aux bornes duquel s'établit une tension $V_{load}$ et un interrupteur rst_load permettant de réaliser la décharge de cet accumulateur avant une opération de lecture du poids synaptique. Lors d'une opération de lecture, l'accumulateur $C_{load}$ est chargé par le courant synaptique, plus ou moins rapidement selon le poids synaptique. La durée de ce chargement peut être estimée très simplement à l'aide d'un comparateur analogique. Sur la figure 15, on considère des synapses à la fois excitatrices et inhibitrices et on prévoit donc deux comparateurs Cp et Cn chargés de comparer la tension aux bornes accumulateur de courant synaptique $C_{load}$ respectivement à un premier seuil Sp (par exemple positif) et à un deuxième seuil Sn (par exemple négatif). Sur les chronogrammes à gauche sur la figure 15, la synapse est excitatrice et la tension $V_{load}$ aux bornes de l'accumulateur de courant synaptique $C_{load}$, après qu'il ait été déchargé, augmente progressivement jusqu'à dépasser le premier seuil Sp et faire basculer la sortie Comp_exci du comparateur Cp qui fournit ainsi une information de durée de chargement qui est représentative du poids synaptique.

La sortie Comp_exci du comparateur Cp est fourni au circuit logique LOG interposé entre le circuit de lecture CL3 et le circuit d'intégration CI3. Ce circuit logique est configuré pour générer, à partir du résultat de la comparaison, une impulsion en tension présentant ladite durée, en l'occurrence l'impulsion Cmd_exci dans l'exemple de la figure 15.

Le circuit d'intégration CI2 comprend quant à lui une source de courant $SI_{exc}$ pilotée par ladite impulsion Cmd_exci pour injecter un courant dans l'accumulateur de poids synaptiques $C_{mem}$ pendant ladite durée. La durée de cette injection de courant dépend donc de la valeur du poids synaptique, de sorte que la valeur finale de la tension de membrane $V_{mem}$ dépend également de la valeur du poids synaptique.

Dans l'exemple représenté à synapses excitatrices et inhibitrices, le circuit d'intégration CI2 comprend une autre source de courant $SI_{inhi}$ pilotée par une impulsion en tension Cmd_inhi pour tirer du courant depuis l'accumulateur de poids synaptiques $C_{mem}$ pendant une durée représentative du poids synaptique.

Le neurone de la figure 15 peut en outre prendre en compte le signe de l'impulsion présynaptique, celui-ci Signe_spike étant fourni au circuit logique LOG qui est alors configuré pour déterminer le signe d'intégration à partir du signe du spike et d'une information de signe de poids synaptique synapse déterminé par celui des comparateurs Cp et Cn qui commute. Ce traitement logique et économique du signe du spike permet, particulièrement dans le cas de cellules 1T1R, d'alléger le plan synaptique et sa gestion. On relèvera que la synapse valeur absolue + signe est particulièrement adaptée à ce neurone.

Un avantage de cette réalisation est la fiabilité des poids nuls. Dans le cas d'un poids nul, tous les dispositifs RRAMs de la synapse sont à HRS. Donc, d'une part, la constante de temps associée à une synapse de poids nulle est bien plus importante que les autres et, d'une autre part, on aura Rexci ≈ Rinhi. Il est donc peu probable que la tension $V_{load}$ franchise l'un des deux seuils Sp, Sn non seulement parce qu'elle n'en aura pas le temps mais aussi parce que sa valeur finale risque d'être comprise entre les deux seuils. Dès lors le circuit logique LOG ne voit pas de commutation en sortie des comparateurs Cp, Cn et ne déclenche aucune injection de charge sur $C_{mem}$. Un véritable poids nul qui ne modifie absolument en rien l'état du neurone est ainsi implémenté.

On a représenté sur la figure 16 des chronogrammes illustrant un autre mode de fonctionnement du neurone de la figure 15 selon lequel une double lecture est opérée de manière à être insensible aux délais de commutation des comparateurs Cp, Cn. En effet, suivant les technologies RRAM et transistors utilisées et la consommation des comparateurs, il est possible que le temps de commutation $T_{comp}$ de ces derniers ne soit pas négligeable devant le temps de chargement de l'accumulateur $C_{load}$. Dans ce cas, la durée de l'impulsion transmise au circuit d'intégration risque de peu varier avec la valeur de $R_{syn}$, ce qui peut s'avérer préjudiciable. Dans cet autre mode de fonctionnement, l'impulsion est générée à partir de deux commutations de comparateur, sa durée correspondant à une durée séparant le franchissement du seuil associé à l'un des comparateurs puis le franchissement du seuil associé à l'autre des comparateurs. Les délais de commutation sont ainsi appliqués sur le début et la fin de l'impulsion et n'affectent donc pas sa durée.

Ainsi, dans un premier temps, la synapse est lue dans un sens suffisamment longtemps pour que $V_{load}$ parte en buttée sur $V_{read}$ ou $-V_{read}$ selon le signe de la synapse. Puis, on inverse la polarisation de la lecture, la tension $V_{load}$ va donc traverser la différence de potentiel d'une polarisation de $V_{read}$ à l'autre et franchir les deux seuils Sp, Sn en un temps relatif au poids de la synapse. Le circuit logique LOG est alors configuré pour générer une impulsion en tension entre ces deux commutations de comparateurs.

On a représenté sur les figures 17 à 20 des exemples de réalisation d'un neurone artificiel ne relevant pas de l'invention et pour lesquels la grandeur analogique représentative du poids synaptique fournie par le circuit de lecture au circuit d'intégration est un courant. Dans les exemples des figures 17 et 18, le circuit de lecture CL4, CL5 comprend un convoyeur de courant qui comporte un port d'entrée X destiné à être reliée à la synapse via la ligne de bit, un port d'entrée Y destiné à se voir imposer une tension fixe (par exemple la masse) pendant la durée de l'accès à la synapse et un port de sortie Z relié au circuit d'intégration.

Un tel convoyeur de courant, basé sur un amplificateur opérationnel et deux miroirs de courant, est tel que la tension fixe imposée sur le port d'entrée Y est recopiée sur le port d'entrée X et le courant injecté dans le port d'entrée X est reproduit sur le port de sortie Z (avec une inversion de signe pour le circuit de la figure 17, sans inversion de signe pour le circuit de la figure 18). Une tension fixe étant imposée au port Y, on vient asservir la tension de ligne de bit à cette tension fixe (elle est ainsi indépendante de la tension de membrane du neurone) et débiter le courant synaptique sur le port de sortie Z. Ce courant synaptique est fourni au circuit d'intégration qui va alors en réaliser une intégration analogique.

La constante de temps $R_{syn}$-$C_{mem}$ peut toutefois s'avérer trop brève pour que l'amplificateur opérationnel et les miroirs de courant composant le convoyeur de courant fonctionnement correctement. Ainsi, dans une variante de réalisation, le convoyeur de courant comprend, comme représenté en figure 19, un miroir de courant configuré pour réaliser un abaissement du courant entre le port d'entrée X et le port de sortie Z. sur cette figure, on a effectivement $I_{OUT} = \dfrac{-I_{IN}}{K}$, avec K un facteur supérieur à 1 qui permet d'utiliser des impulsions de lecture de durée plus longues et donc plus adaptées au fonctionnement des éléments actifs sans pour autant faire saturer la capacité de membrane.

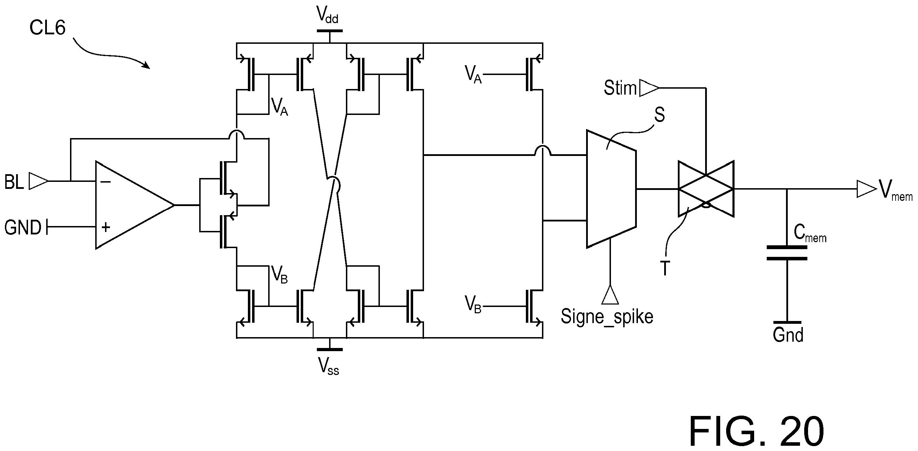

Dans une variante de réalisation représentée sur la figure 20, le neurone comprend une porte de transmission T entre le circuit de lecture et le circuit d'intégration. Cette porte permet de dissocier le temps d'accès aux RRAMs et le temps d'intégration, ce qui permet d'attendre que la tension sur le port d'entrée X se stabilise avant d'intégrer le courant de lecture et de jouer avec une impulsion d'intégration brève sans que cela ne requiert un amplificateur opérationnel particulièrement réactif.

Par ailleurs, sur cette figure 20 le circuit de lecture CL6 comprend avantageusement à la fois le miroir de courant inverseur du circuit de lecture CL4 et le miroir de courant non-inverseur du circuit de lecture CL5 (ces miroirs pouvant réaliser un abaissement du courant conformément à la figure 19) et un sélecteur S commandé par un signal Signe_spike représentatif du signe du spike présynaptique pour venir sélectionner la sortie de l'un ou l'autre de ces miroirs de courant.

L'invention n'est pas limitée au neurone artificiel précédemment décrit, mais s'étend à une puce neuromorphique comprenant une pluralité de synapses à mémoire résistive agencées en un réseau à lignes et colonnes transversales. Chaque synapse dispose d'une borne de propagation, les bornes de propagation des synapses d'une même colonne étant reliées entre elles et connectées à un neurone artificiel selon l'invention. Les synapses peuvent être des synapses excitatrices ou inhibitrices telles que celles présentées précédemment en liaison avec les figures 6 à 11.

**Revendications**

1. Neurone artificiel (NA) pour puce neuromorphique comprenant une synapse à mémoire résistive représentative d'un poids synaptique,

   le neurone artificiel comportant un circuit d'intégration (CI3) qui comprend un accumulateur de poids synaptiques ($C_{mem}$) aux bornes duquel s'établit une tension de membrane ($V_{mem}$) et un comparateur (COMP) configuré pour émettre une impulsion postsynaptique en cas de franchissement d'un seuil par la tension de membrane,
le neurone artificiel étant **caractérisé en ce qu'**il comporte en outre :

un circuit de lecture (CL3) qui comprend un accumulateur de courant synaptique (C_load), le circuit de lecture (CL3) étant configuré pour imposer à la synapse une tension de lecture indépendante de la tension de membrane, pour déterminer une information de durée de chargement de l'accumulateur de courant synaptique (C_load) et pour fournir une grandeur analogique représentative du poids synaptique (PSa), ladite grandeur analogique étant ladite information de durée de chargement;
un circuit logique (LOG) interposé entre le circuit de lecture (CL3) et le circuit d'intégration (CI3), le circuit logique étant configuré pour générer à partir de ladite grandeur analogique une impulsion (Cmd_exci, Cmd_inhi) ayant pour durée la durée de chargement de l'accumulateur de courant synaptique (C_load); et

**en ce que** le circuit d'intégration (CI3) comprend une source de courant (SI_exc, SI_inhi) pilotée par ladite impulsion pour injecter un courant dans l'accumulateur de poids synaptiques pendant la durée de l'impulsion.

2. Neurone artificiel selon la revendication 1, dans lequel le circuit de lecture (CL3) comprend au moins un comparateur (Cp, Cn) de la tension aux bornes de l'accumulateur de courant synaptique avec un seuil (Sp, Sn) pour fournir un résultat de comparaison constituant ladite grandeur analogique.

3. Neurone artificiel selon la revendication 2 dans lequel l'au moins un comparateur (Cp, Cn) du circuit de lecture (CL3) comprend un premier comparateur (Cp) à un premier seuil (Sp) et un deuxième comparateur (Cn) à un deuxième seuil (Sn) et dans lequel le circuit logique est configuré pour déterminer un signe d'intégration en exploitant un signal (Signe_spike) représentatif d'un signe d'impulsion présynaptique et une information de signe de poids synaptique déterminée par celui des premier et deuxième comparateurs (Cp, Cn) qui commute.

4. Neurone artificiel selon la revendication 2, dans lequel l'au moins un comparateur (Cp, Cn) du circuit de lecture (CL3) comprend un premier comparateur (Cp) à un premier seuil (Sp) et un deuxième comparateur (Cn) à un deuxième seuil (Sn) et dans lequel le circuit logique est configuré de telle manière que la durée de ladite impulsion corresponde à une durée séparant le franchissement de l'un des seuils (Sp, Sn) puis le franchissement de l'autre des seuils (Sp, Sn).

5. Neurone artificiel selon l'une des revendications 1 à 4, dans lequel, la synapse comprenant une mémoire de valeur absolue de poids synaptique (M_abs) et une mémoire de signe de poids synaptique (M_signe), le circuit de lecture comprend un circuit de lecture binaire (Cb) de la mémoire de signe de poids synaptique et un circuit de lecture analogique (Ca) de la mémoire de valeur absolue de poids synaptique M_abs piloté par le circuit de lecture binaire.

6. Puce neuromorphique comprenant une pluralité de synapses à mémoire résistive agencées en un réseau à lignes et colonnes transversales, chaque synapse disposant d'une borne de propagation d'un signal synaptique, les bornes de propagation des synapses d'une même colonne étant reliées entre elles et connectées à un neurone artificiel selon l'une des revendications 1 à 5.

7. Puce neuromorphique selon la revendication 6, dans lequel chaque synapse comprend une composante excitatrice et une composante inhibitrice connectées en série par la borne de propagation de la synapse.

**Patentansprüche**

1. Künstliches Neuron (NA) für einen neuromorphen Chip, enthaltend eine Synapse mit resistivem Speicher, der für ein Synapsengewicht repräsentativ ist,

wobei das künstliche Neuron eine Integrationsschaltung (CI3) umfasst, die einen Synapsengewichtsakkumulator (C_mem), an dessen Anschlüssen sich eine Membranspannung (V_mem) einstellt, und einen Komparator (COMP) umfasst, der dazu ausgelegt ist, einen postsynaptischen Impuls auszusenden, wenn die Membranspannung einen Schwellenwert überschreitet,
wobei das künstliche Neuron **dadurch gekennzeichnet ist, dass** es ferner umfasst:

eine Leseschaltung (CL3), die einen Synapsenstromakkumulator (C_load) umfasst, wobei die Leseschaltung (CL3) dazu ausgelegt ist, der Synapse eine von der Membranspannung unabhängige Lesespannung aufzuprägen, eine Ladezeitdauerinformation des Synapsenstromakkumulators (C_load) zu bestimmen und eine für das Synapsengewicht repräsentative analoge Größe (PSa) bereitzustellen, wobei die analoge Größe die Ladezeitdauerinformation ist;

eine Logikschaltung (LOG), die zwischen Leseschaltung (CL3) und Integrationsschaltung (CI3) geschaltet ist, wobei die Logikschaltung dazu ausgelegt ist, aus der analogen Größe einen Impuls (Cmd_exci, Cmd_inhi) zu erzeugen, der als Zeitdauer die Ladezeitdauer des Synapsenstromakkumulators ($C_{load}$) hat; und

dass die Integrationsschaltung (CI3) eine Stromquelle ($SI_{exc}$, $SI_{inhi}$) umfasst, die von dem Impuls angesteuert wird, um während der Zeitdauer des Impulses einen Strom in den Synapsengewichtsakkumulator einzukoppeln.

2. Künstliches Neuron nach Anspruch 1, wobei die Leseschaltung (CL3) zumindest einen Komparator (Cp, Cn) für die Spannung an den Anschlüssen des Synapsenstromakkumulators mit einem Schwellenwert (Sp, Sn) umfasst, um ein Vergleichsergebnis zu liefern, das die analoge Größe darstellt.

3. Künstliches Neuron nach Anspruch 2, wobei der zumindest eine Komparator (Cp, Cn) der Leseschaltung (CL3) einen ersten Komparator (CP) mit einem ersten Schwellenwert (Sp) und einen zweiten Komparator (Cn) mit einem zweiten Schwellenwert (Sn) umfasst und wobei die Logikschaltung dazu ausgelegt ist, ein Integrationsvorzeichen zu bestimmen, indem sie ein Signal (Signe_spike), das für ein präsynaptisches Impulsvorzeichen repräsentativ ist, und eine Synapsengewichtsvorzeicheninformation auswertet, die von demjenigen aus erstem und zweitem Komparator (Cp, Cn) bestimmt wird, der schaltet.

4. Künstliches Neuron nach Anspruch 2, wobei der zumindest eine Komparator (Cp, Cn) der Leseschaltung (CL3) einen ersten Komparator (Cp) mit einem ersten Schwellenwert (Sp) und einen zweiten Komparator (Cn) mit einem zweiten Schwellenwert (Sn) umfasst und wobei die Logikschaltung so ausgelegt ist, dass die Zeitdauer des Impulses einer Zeitdauer entspricht, die zwischen dem Überschreiten eines der Schwellenwerte (Sp, Sn) und dem Überschreiten des anderen der Schwellenwerte (Sp, Sn) liegt.

5. Künstliches Neuron nach einem der Ansprüche 1 bis 4, wobei bei der Synapse mit einem Speicher für den absoluten Wert des Synapsengewichts ($M_{abs}$) und mit einem Speicher für das Synapsengewichtvorzeichen ($M_{signe}$) die Leseschaltung eine binäre Leseschaltung (Cb) für den Speicher für das Synapsengewichtvorzeichen und eine analoge Leseschaltung (Ca) für den Speicher für den absoluten Wert des Synapsengewichts $M_{abs}$ umfasst, die von der binären Leseschaltung angesteuert wird.

6. Neuromorpher Chip mit einer Vielzahl von Synapsen mit resistivem Speicher, die in einem Netzwerk mit Zeilen und quer verlaufenden Spalten angeordnet sind, wobei jede Synapse über einen Anschluss zur Ausbreitung eines synaptischen Signals verfügt, wobei die Synapsenausbreitungsanschlüsse in derselben Spalte miteinander verbunden und an ein künstliches Neuron nach einem der Ansprüche 1 bis 5 angeschlossen sind.

7. Neuromorpher Chip nach Anspruch 6, wobei jede Synapse eine erregende Komponente und eine hemmende Komponente umfasst, die durch den Synapsenausbreitungsanschluss in Reihe geschaltet sind.

## Claims

1. Artificial neuron (NA) for a neuromorphic chip comprising a synapse with resistive memory representative of a synaptic weight,

the artificial neuron including an integration circuit (CI3) that comprises an accumulator of synaptic weights ($C_{mem}$) at the terminals of which a membrane voltage ($V_{mem}$) is established and a comparator (COMP) configured to emit a postsynaptic pulse if a threshold is exceeded by the membrane voltage, the artificial neuron being **characterised in that** it further includes:

a read circuit (CL3) which comprises a synaptic current accumulator ($C_{load}$), the read circuit (CL3) being configured to impose on the synapse a read voltage independent of the membrane voltage, to determine a piece of information on charging duration of the synaptic current accumulator ($C_{load}$) and to provide an analogue value representative of the synaptic weight (PSa), said analogue value being said piece of information on charging duration;
a logic circuit (LOG) interposed between the read circuit (CL3) and the integration circuit (CI3), the logic circuit being configured to generate from said analogue value a pulse (Cmd_exci, Cmd_inhi) having as duration the charging duration of the synaptic current accumulator ($C_{load}$); and

**in that** the integration circuit (CI3) comprises a source of current ($SI_{exc}$, $SI_{inhi}$) controlled by said pulse to inject a current into the accumulator of synaptic weights during the duration of the pulse.

2. Artificial neuron according to claim 1, wherein the read circuit (CL3) comprises at least one comparator (Cp, Cn) of the voltage at the terminals of the accumulator of synaptic current to a threshold (Sp, Sn) to provide a comparison result constituting said analog value.

3. Artificial neuron according to claim 2, wherein the at least one comparator (Cp, Cn) of the read circuit (CL3) comprises a first comparator(Cp) to a first threshold (Sp) and a second comparator (Cn) to a second threshold (Sn) and wherein the logic circuit is configured to determine an integration sign by using a signal (Signe_spike) representative of a sign of presynaptic pulse and a piece of information on sign of synaptic weight that is determined by that of the first and second comparators (Cp, Cn) that switches.

4. Artificial neuron according to claim 2, wherein the at least one comparator (Cp, Cn) of the read circuit (CL3) comprises a first comparator (Cp) to a first threshold (Sp) and a second comparator (Cn) to a second threshold (Sn) and wherein the logic circuit is configured in such a way that the duration of said pulse corresponds to a duration separating the exceeding of one of the thresholds (Sp, Sn) and then the exceeding of the other of the thresholds (Sp, Sn).

5. Artificial neuron according to one of claims 1 to 4, wherein, the synapse comprising a memory of absolute value of synaptic weight ($M_{abs}$) and a memory of sign of synaptic weight ($M_{signe}$), the read circuit comprises a circuit (Cb) for binary reading of the memory of sign of synaptic weight and a circuit (Ca) for analogue reading of the memory of absolute value of synaptic weight ($M_{abs}$) controlled by the circuit for binary reading.

6. Neuromorphic chip comprising a plurality of synapses with resistive memory arranged in an array of transverse lines and columns, each synapse having a terminal for propagation of a synaptic signal, the propagation terminals of the synapses of the same column being connected to each other and connected to an artificial neuron according to one of claims 1 to 5.

7. Neuromorphic chip according to claim 6, wherein each synapse comprises an excitatory component and an inhibitory component connected in series by the propagation terminal of the synapse.

FIG. 1

FIG. 2

$R_{syna}$

$R_{synb}$

$V_{spike\_pre}$

$I_{synb}$

$C_{mem}$

$V_{mem}$

$V_{seuil}$

$V_{spike}$

FIG. 3

$R_{synb}$

$I_{synb}$

$V_{mem}$

$V_{spike\_pre}$

FIG. 4

NA

BL

CL

PSa

CI

ACC

COMP

So

$V_{seuil}$

$V_{mem}$

FIG. 5

FIG. 6

FIG. 7

FIG. 8

FIG. 9

FIG. 10

FIG. 11

FIG. 12

FIG. 13

FIG. 14

FIG. 15

FIG. 16

CL4

FIG. 17

CL5

FIG. 18

FIG. 19

FIG. 20

**RÉFÉRENCES CITÉES DANS LA DESCRIPTION**

**Littérature non-brevet citée dans la description**

- **A. VAN SCHAIK.** Building blocks for electronic spiking neural networks. *Neural Networks,* 09 Juillet 2001, vol. 14, 617-628